# EUROPEAN PATENT SPECIFICATION

(11) **EP 0 344 406 B1**
(45) Date of publication and mention of the grant of the patent: **29.05.1996**
(21) Application number: 89102644.5
(22) Date of filing: 16.02.1989
(51) Int. Cl.: H01L 39/12, H01L 39/24, C04B 35/00

(54) **Tl-based copper oxide superconductor**
Tl-Kupferoxid-Supraleiter
Supraconducteur en oxyde de cuivre à base de Thallium

(30) Priority: 01.06.1988 JP 134909/88
(43) Date of publication of application: 06.12.1989
(73) Proprietor: The Agency of Industrial Science and Technology, Chiyoda-ku Tokyo-to (JP)
(72) Inventor: Ihara, Hideo c/o Electrotechnical Laboratory, Tsukuba-shi Ibaraki (JP); Hirabayashi, Masayuki c/o Electrotechnical Lab., Tsukuba-shi Ibaraki (JP)
(74) Representative: Bühling, Gerhard, Dipl.-Chem.

(56) References cited:
- EP-A- 0 299 870
- WO-A-88/10009
- NATURE, vol. 332, 10th March 1988, pages 138-139, Basingstoke, GB; Z.Z. SHENG et al.: "Bulk superconductivity at 120 K in the Tl-Ca/Ba-Cu-O system"
- IEEE TRANSACTIONS OF MAGNETICS, vol. 25, no. 2, March 1989, pages 2587-2590, IEEE, New York, US & APLLIED SUPERCONDUCTIVITY CONFERENCE, 21st-25th August 1988, San Francisco, US; H. IHARA et al.: "New Tl-Ba-Ca-Cu-O (1234 and 1245) superconductors with Tc 117 K"
- NATURE, vol. 334, no. 6182, 11th August 1988, pages 510-511, London, GB; H. IHARA et al.: "A new high-Tc TlBa2Ca3Cu4O11 superconductor with Tc 120 K"
- JAPANESE JOURNAL OF APPLIED PHYSICS, vol. 27, no. 6, June 1988, pages L1054 - L1057, Tokyo, JP; S. IIJIMA et al.: "Intergrowth structures in superconductor Tl-Ba-Ca-Cu-O oxides"
- PHYSICAL REVIEW LETTERS, vol. 60, no. 24, 13th June 1988, pages 2539-2542, The American Physical Society, New York, US; S.S.P. PARKIN et al.: "Bulk superconductivity at 125 K in Tl2Ca2Ba2Cu3Ox"
- JOURNAL OF SUPERCONDUCTIVITY, vol. 1, no. 2, June 1988, pages 211-218, Bristol, GB; P. HALDAR et al.: "A new high-Tc superconductor containing thallium and its crystal structure: The "1212" phase (Tl1-xBix)1.33Sr1.33Ca1.33Cu206.67+delta"
- Proc. MRS Intern. Meeting on Advanced Materials, May 1988, Tokyo; communication of H. IHARA et al. : "Superconductivity of new high-Tc Tl1-Ba2-Ca3-Cu4-O11 (1234) superconductor"
- Physical Review Letters, vol. 60, no. 16, 18 April 1988, pages 1657-1660, New York, US; R. M. HAZEN et al. : "100 K superconducting phases in the TL-Ca-Ba-Cu-O system"
- Physical Review Letters, vol. 58, no. 9, 2 March 1987, pages 908-910, M. K. WU et al. : "Superconductivity at 93 K in a new mixed-phase Y-Ba-Cu-O compound system at ambient pressure"

## Description

The present invention relates to superconductors having high critical superconducting temperatures, and particularly to a Tl, In, Ca, Sb or Bi system superconductor capable of being used even at or above the liquid nitrogen temperature.

Conventional superconductors include Tl₂Ba₂Ca₁Cu₂Oy (commonly called "2212") and, Tl₂Ba₂Ca₂Cu₃Oy (commonly called "2223"). Among them, Tl₂Ca₂Ba₂Cu₃Oy is reported to have a maximum value of Tc (critical superconducting temperature) as high as about 120K.

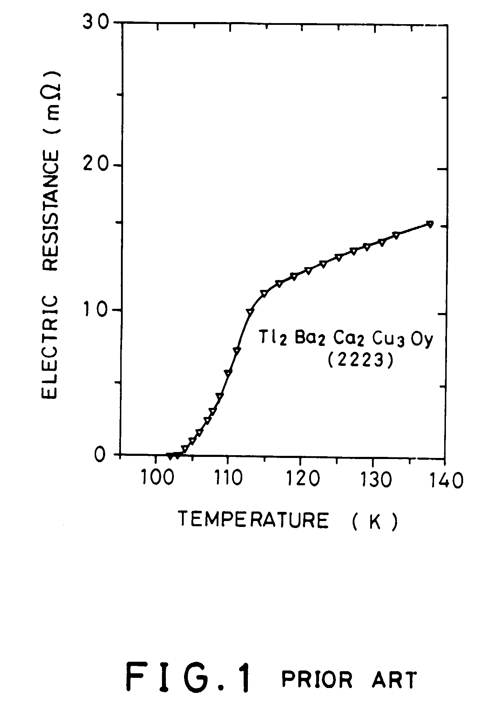

Fig. 1 shows the relationships between the electric resistance and the temperature as regards conventional Tl system superconductors. In Fig. 1, the curve shows the relationship between the electric resistance of Tl₂Ba₂Ca₂Cu₃Oy and the temperature. It has a value of Tc of about 110K.

Tl has the high toxicity, and the natural resources of it are poor. However, most of conventional Tl system superconductors have a high Tl content, which present grave problems including difficulties in taking a measure for elimination of toxicity in an aspect of production technique, reducing the production cost, and securing the Tl resources.

In the Proc. MRS Intern. Meeting on Advanced Materials by H. Ihara (May 1988, Tokyo), a superconductor represented by the formula TlBa₂Caₙ₋₁CuₙO₂ₙ₊₃ (n = 1, 2, 3, 4, 5 ...) is disclosed. R. M. Hazen disclosed, in Physical Review Letters, April 1988, vol. 60, No. 16, pp. 1657-1660, a superconducting phase characterized by the formula Tl₂Ca₂Ba₂Cu₃O_{10+δ.}

An object of the present invention is to solve the above-mentioned problems to thereby provide a Tl, In, Ga, Sb or Bi system superconductor having a low Tl content and hence a low toxicity which is nevertheless high in superconducting transition temperature.

Another object of the present invention is to increase layers of Cu-O by reducing Tl content thereby improving superconductive characteristics of Tl system superconductors.

A further object of the present invention is to decrease the toxity of the multi layers CuO system superconductors to substitute part of Tl with In, Ga, Sb or Bi.

In the first aspect of the present invention, a superconductor comprises a composition represented by the formula: (TlₐM₁₋ₐ)Ba₂CaₓCuₓ₊₁O_{y}, wherein 0≤x≤10, 0<a<1, and M is chosen in the group comprising In, Ga, Sb and Bi.

In the second aspect of the present investion, a superconductor has a composition represented by the formula: (TlₐM₂₋ₐ)Ba₂CaₓCuₓ₊₁O_{y} wherein 2≤x≤10, 0<a<2, and M is chosen in the group comprising In, Ga, Sb and Bi.

In the third aspect of the present invention, a process according to claim 3 is provided.

In the fourth aspect of the present invention, a process according to claim 4 is provided.

Superconductors comprising the above compositions are Tl system superconductors having a lower Tl content than conventional Tl system superconductors and hence lower in toxicity attributed to Tl. Nevertheless, the critical superconducting temperatures of the superconductors are substantially the same as those of the conventional Tl system superconductors. Superconductors in the form of modifications of the above-mentioned superconductors wherein part of Tl is substituted with In, Ga, Sb or Bi are lower in toxicity than the conventional Tl system superconductors and substantially the same in critical superconducting temperature as the conventional Tl system superconductors.

The above and other objects, effects, features and advantages of the present invention will become more apparent from the following description of embodiments thereof taken in conjunction with the accompanying drawings.
Fig. 1 is a diagram showing the relationships between the electric resistance and the temperature in a conventional superconductor;
Fig. 2 is a diagram showing the relationship between the electric resistance and the temperature of an example of the superconductor according to the present invention; and
Fig. 3 is an X-ray diffraction pattern of an example of the superconductor according to the present invention.

The present invention will now be described in detail while referring to the accompanying drawings.

First, the processes for producing TlBa₂CaₓCuₓ₊₁O_{y} will be described. TlBa₂CaₓCuₓ₊₁O_{y} can be prepared either by the sintering process or by the sputtering process.

### Sintering process

(1) Powders of each of Tl₂O₃, CaO, CuO and BaCuO₄ are mixed together at such a ratio as to provide a composition: Tl₄Ba₂CaₓCuₓ₊₁O_{y}, and the resulting mixture is formed into a pellet having a diameter of 10 mm and a thickness of 1mm.
(2) The pellet is sintered in a stream of oxygen at 880 to 920°C for 10 minutes, and is furnace-cooled at a rate of 100°C/hour. The Tl content of the sintered pellet can be controlled by adequately adjusting the sintering time and temperature.
(3) The sintered pellet is annealed in a high-pressure atmosphere of oxygen at 400°C for 3 hours. However, this step may be dispensed with.

In the above-mentioned procedure, BaO₂ and CuO powders may be used instead of the BaCuO₄ powder and CaO₂ may be used instead of CaO. In any case, the starting material powders are mixed together at such a ratio as to provide a composition: Tl₄Ba₂CaₓCuₓ₊₁O_{y} in principle. However, the starting material powders may be mixed together to set the Tl content of the resulting mixture so low as to provide a composition: TlₙBa₂CaₓCuₓ₊₁O_{y} wherein n = 0.5 - 3.

The mixture of the starting material powders may be formed into a fiber instead of the above-mentioned pellet.

### Sputtering process

A superconductor is produced by a sputtering method using a Tl-Ca-Ba-Cu-O system target and a substrate temperature of around 500°C. Since the sputtered superconductor is lacking in Tl atom, the superconductor is baked in oxygen gas together with thallium oxide at 850-900°C to adjust the composition.

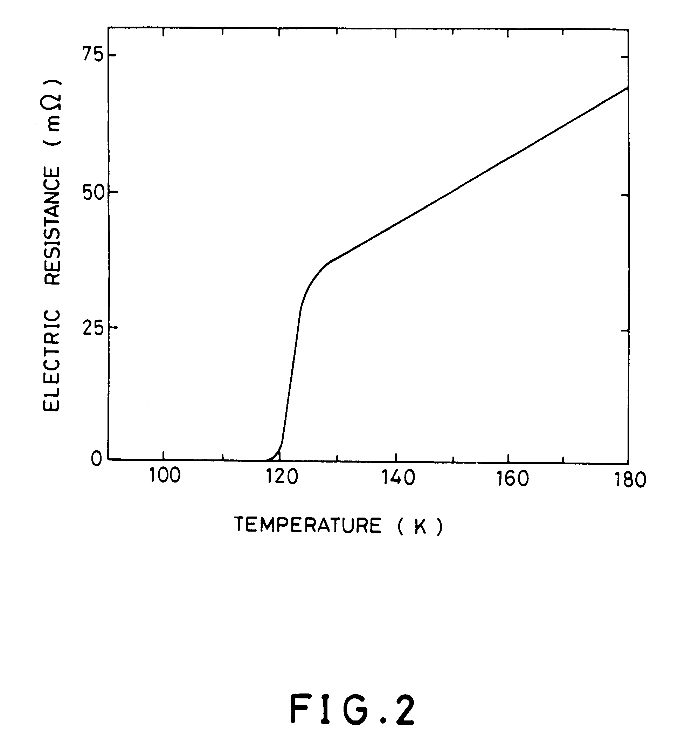

Fig. 2 shows the relationship between the electric resistance and the temperature of an example of the superconductor according to the present invention. Fig. 2 reveals that the critical superconducting temperature thereof ranges from 120K to 131K.

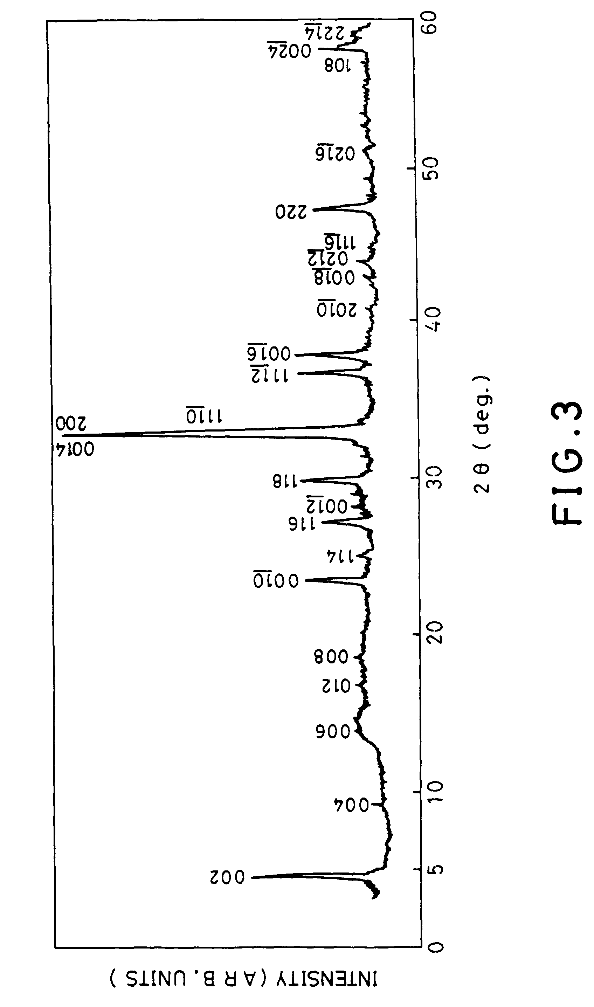

Fig. 3 shows the X-ray diffraction pattern of an example of the superconductor of the present invention, which is suggestive of lattice constants: a=0.385 nm (3.85Å) and c=1.91 nm (19.1Å).

The Tl content of TlBa₂Ca₃Cu₄O_{y} decreases to about 1/4 of that of a conventional Tl system superconductor (Tl₂Ba₂CaₗCu₂O_{y}). Tl₂Ba₂CaₓCuₓ₊₁O_{y} (2≤x≤10), the Tl content of which is about 1/2 of that of the conventional superconductor, also shows a high value of Tc just like TlBa₂CaₓCuₓ₊₁O_{y}.

Increases in the value of x in TlBa₂CaₓCuₓ₊₁O_{y} and Tl₂Ba₂CaₓCuₓ₊₁O_{y} lead to maximum values of Tc at x = 3 and around x = 2, respectively. Further increases in the value of x in them result in respective decreasing values of Tc. It can be concluded that 10 is the upper limit of the x value range within which both of TlBa₂CaₓCuₓ₊₁O_{y} and Tl₂Ba₂CaₓCuₓ₊₁O_{y} can have superconductivity.

Substitution of part of T1 in either TlBa₂CaₓCuₓ₊₁O_{y} or Tl₂Ba₂CaₓCuₓ₊₁O_{y} with In, Ga, Sb or Bi should be able to serve to further decrease the toxicity thereof.

However it is difficult at present to substitute Tl with In, Ga, Sb or Bi as far as any customary powder sintering process is used.

Thus, superconductors except a Tl system superconductor were produced by a process of reacting a solution of nitrates. For example, in case of producing an In system oxide superconductor, nitrates of each of In, Ca, Ba and Cu are dissolved in water together with at such a ratio as to provide a compostion: InBa₂Ca₃Cu₄O_{y}, subsequently, the resulting solution is reacted by spraying it on an alumina substrate heated at 600°C to form an In system suprconductor. Tl, Ga, Sb, or Bi system superconductors may be produced by the same process of producing the In superconductors.

Further, a superconductor thin film may be formed by the sputtering process or the molecular beam epitaxial growth process which are suitable for forming a substance with a lamellar structure. First, a superconductor thin film containing no Tl is formed, and the film is treated in a Tl oxide gas to form a thin film of a superconductor containing Tl, this superconductor is the same as described above where in part of Tl is stubstituted with In, Ga, Sb or Bi. A superconductor thin film of In, Ga, Sb or Bi system containing no Tl is formed, when the step fo the treatment in a Tl oxide is dispensed with.

By way of example, a thin film of a superconductor substance of the kind as described above wherein Tl is substituted with In is formed according to the following procedure.

According to the sputtering process, CaₓCuₓ₊₁, BaO, In₂O₃ and BaO are repeatedly deposited in this order on an SrTiO₃ substrate heated at about 700°C by using three targets respectively made of CaₓCuₓ₊₁O_{y} or CaₓCuₓ₊₁O_{y} containing about 5 % of Sr added thereto, BaO, and In₂O₃ to form a superconductor thin film having a composition: InBa₂CaₓCuₓ₊₁O_{y} and a simple tetragonal and lamellar perovskite structure.

In this process, since indium oxide is difficult to evaporate unlike thallium oxide, deposition ot a thin film in layers at a low temperature close to room temperature may be followed by an annealing treatment in oxygen at about 900°C to crystallize the deposited thin film and to form the superconductor film.

The thin film of InBa₂CaₓCuₓ₊₁O_{y} thus formed by sputtering deposition is placed in a Tl oxide gas and treated therein at around 900°C to be able to form a thin film wherein part of Tl in TlBa₂CaₓCuₓ₊₁O_{y} is substituted with In.

According to the molecular beam epitaxial growth process, molecular and atomic layers of InO_{1.5}, BaO, CuO₂, Ca, CuO₂, Ca, CuO₂ and BaO are deposited in this order on a substrate to form a thin film having a four-Cu-layer structure and a high value of Tc.

The thin film described just above is placed in a Tl oxide gas and treated therein at around 900°C as in the case of the sputtering process to be able to form a thin film wherein part of Tl in TlCaₓBa₂Cuₓ₊₁O_{y} is substituted with In.

The values of Tc of superconductor thin films except of Tl system superconductor formed according to either of the above-mentioned procedures are lower at present than that of the unsubstituted Tl system superconductor as shown in Fig. 2. However, there is a possibility that the value of Tc can be raised by optimizing the composition and the conditions used for the formation of a thin film.

Thin films wherein part of Tl is substituted with Ga, Sb or Bi instead of In can also be formed using either of substantially the same procedures as described above.

While the procedures of forming TlBa₂CaₓCuₓ₊₁O_{y} have been described in the above-mentioned example, Tl₂Ba₂CaₓCuₓ₊₁O_{y} can also be prepared in any one of substantially the same manners as described above.

As described above, the present invention can provide the following advantages.
(1) According to the present invention, Tl system superconductors having a low Tl content can be materialized.
(2) Substitution of part of Tl in a composition represented by the formula: TlBa₂CaₓCuₓ₊₁O_{y} as well as Tl₂Ba₂CaₓCuₓ₊₁O_{y} with In, Ga, Sb or Bi can achieve expanded room for choosing the starting materials for Tl system superconductors and a reduction in the toxicity thereof.
(3) Nevertheless, the superconduction characteristics of the Tl system superconductors according to the present invention are not downgraded. It is even possible according to the present invention to realize superconduction characteristics equivalent or superior to those of superconductors having a high Tl content.
(4) Thus, the present invention can achieve a reduction in the toxicity of Tl system superconductors, a reduction in the cost of anti-poisoning equipment used in the process for producing the same, retrenchment of the Tl resources, expanded room for choosing starting materials, and a reduction in the production cost.

The invention has been described in detail with respect to preferred embodiments, and it will now be apparent from the foregoing to those skilled in the art that changes and modifications may be made without departing from the invention in its broader aspects as set out in the appended claims.

## Claims

1. A superconductor characterized by comprising a composition represented by the formula:
(TlₐM₁₋ₐ)Ba₂CaₓCuₓ₊₁O_{y},
where 0 ≤ x ≤ 10, 0 < a < 1, and M is chosen in the group comprising In, Ga, Sb and Bi.

2. A superconductor characterized by having a composition represented by the formula:
(TlₐM₂₋ₐ)Ba₂CaₓCuₓ₊₁O_{y}
where 2 ≤ x ≤ 10, 0 < a < 2, and M is chosen in the group comprising In, Ga, Sb and Bi.

3. A process for producing a superconductor according to claims 1 or 2, characterized by comprising the steps of:
repeatedly depositing CaₓCuₓ₊₁, BaO, M₂O₃ and BaO in the named order on a substrate by sputtering using three targets respectively made of Ca_{X}Cuₓ₊₁O_{y}, BaO, and M₂O₃ (M is an element selected from among In, Ga, Sb and Bi); and optionally treating the resulting sputtering-deposited MBa₂CaₓCuₓ₊₁O_{y} thin film in a Tl oxide gas to add Tl to said deposited film and to substitute part of M by Tl.

4. A process for producing a superconductor according to claim 1, characterized by comprising the steps of:
sequentially depositing molecular and atomic layers of MO_{1.5}, BaO, CuO₂, Ca, CuO₂, Ca, CuO₂, Ca, CuO₂ and BaO in the named order on a substrate from molecular beam sources respectively made of M, Cu, Ba and Ca in an oxygen gas atmosphere (M is an element selected from among In, Ga, Sb and Bi); and
optionally treating the resulting deposited MBa₂CaₓCuₓ₊₁O_{y} thin film in a Tl oxide gas to add Tl to said deposited film and to substitute part of M by Tl.

## Patentansprüche

1. Supraleiter,
**dadurch gekennzeichnet,daß**
er eine durch die nachstehende Formel:
(TlₐM₁₋ₐ)Ba₂CaₓCuₓ₊₁O_{y}
repräsentierte Zusammensetzung umfaßt, wobei 0 ≤ x ≤ 10, 0 < a < 1, und M aus der Gruppe bestehend aus In, Ga, Sb und Bi ausgewählt ist.

2. Supraleiter,
**dadurch gekennzeichnet,daß**
er eine durch die nachstehende Formel:
(TlₐM₂₋ₐ)Ba₂CaₓCuₓ₊₁O_{y}
repräsentierte Zusammensetzung aufweist, wobei 2 ≤ x ≤ 10, 0 < a < 2 und M aus der Gruppe bestehend aus In, Ga, Sb und Bi ausgewählt ist.

3. Verfahren zur Herstellung eines Supraleiters nach Anspruch 1 oder 2,
**dadurch gekennzeichnet,daß**
es die nachstehenden Schritte umfaßt:
das wiederholte Abscheiden von CaₓCuₓ₊₁, BaO, M₂O₃ und BaO in der genannten Reihenfolge auf einem Substrat mittels Vakuumaufstäubung unter Verwendung dreier Targets, die jeweils aus CaₓCuₓ₊₁O_{y}, BaO und M₂O₃ (M ist ein Element, ausgewählt aus In, Ga, Sb und Bi) gefertigt sind ; und gegebenenfalls eine Behandlung der resultierenden, durch Vakuumaufstäuben abgeschiedenen MBa₂CaₓCuₓ₊₁O_{y},-Dünnschicht in einem Tl-Oxid-Gas, um Tl zu der abgeschiedenen Schicht hinzuzufügen und einen Teil von M durch Tl zu ersetzen.

4. Verfahren zur Herstellung eines Supraleiters nach Anspruch 1,
**dadurch gekennzeichnet,daß**
es die nachstehenden Schritte umfaßt:
das aufeinanderfolgende Abscheiden molekularer und atomarer Schichten aus MO_{1,5}, BaO, CuO₂, Ca, CuO₂, Ca, CuO₂, Ca, CuO₂ und BaO in der genannten Reihenfolge auf einem Substrat, aus Molekülstrahlquellen, die jeweils aus M, Cu, Ba und Ca gefertigt sind, in einer Sauerstoffgasatmosphäre (M ist ein Element, das aus In, Ga, Sb und Bi ausgewählt ist); und gegebenenfalls eine Behandlung der resultierenden abgeschiedenen MBa₂CaₓCuₓ₊₁O_{y}-Dünnschicht in einem Tl-Oxid-Gas, um Tl zu der abgeschiedenen Schicht hinzuzufügen und einen Teil von M durch Tl zu ersetzen.

## Revendications

1. Supraconducteur, caractérisé en ce qu'il comprend une composition représentée par la formule
(TlₐM₁₋ₐ)Ba₂CaₓCuₓ₊₁O_{y},
dans laquelle 0 ≤ x ≤ 10, 0 < a < 1, et M est choisi dans le groupe comprenant In, Ga, Sb et Bi.

2. Supraconducteur, caractérisé en ce qu'il a une composition représentée par la formule
(TlₐM₂₋ₐ)Ba₂CaₓCuₓ₊₁O_{y},
dans laquelle 2 ≤ x ≤ 10, 0 < a < 2, et M est choisi dans le groupe comprenant In, Ga, Sb et Bi.

3. Procédé de préparation d'un supraconducteur suivant les revendications 1 ou 2, caractérisé en ce qu'il comprend les étapes :
de dépôt de manière répétée de CaₓCuₓ₊₁, BaO, M₂O₃ et BaO dans l'ordre indiqué sur un substrat par pulvérisation cathodique en utilisant trois cibles respectivement en CaₓCuₓ₊₁C_{y}, BaO et M₂O₃ (M est un élément choisi parmi In, Ga, Sb et Bi); et éventuellement de traitement de la mince pellicule de MBa₂CaₓCuₓ₊₁O_{y} déposée par pulvérisation cathodique dans un oxyde de Tl gazeux pour ajouter du Tl à la pellicule déposée et pour remplacer une partie de M par Tl.

4. Procédé de préparation d'un supraconducteur suivant la revendication 1, caractérisé en ce qu'il comprend les étapes :
de dépôt séquentiel de couches moléculaires et atomiques de Mo_{1,5}, BaO, CuO₂, Ca, CuO₂, Ca, CuO₂, Ca, CuO₂ et BaO dans l'ordre indiqué sur un substrat à partir de sources de faisceaux moléculaires respectivement en M, Cu, Ba et Ca dans une atmosphère d'oxygène gazeux (M est un élément choisi parmi In, Ga, Sb et Bi); et
éventuellement de traitement de la mince pellicule de MBa₂CaₓCuₓ₊₁O_{y} déposée obtenue dans un oxyde de Tl gazeux pour ajouter du Tl à la pellicule déposée et pour remplacer une partie de M par Tl.
